# EUROPEAN PATENT APPLICATION

(11) **EP 4 644 469 A1**
(43) Date of publication of application: **05.11.2025**
(21) Application number: 24173207.2
(22) Date of filing: 29.04.2024
(51) Int. Cl.: C08J 5/18, A01G 9/14, H10K 30/50, A01G 9/24

(54) **VISIBLE LIGHT ENHANCEMENT FILM**

(71) Applicant: Season Agricultural Technology Co., Ltd., Tainan City 711011 (TW)
(72) Inventor: Chang, Lin-Hung, 711011 Tainan City (TW)
(74) Representative: Heisel, Wolfgang

(57) **Abstract**

A visible light enhancement film (100) includes a film body (10), a graphene unit (20) mounted in the film body, and a photocatalyst unit (30) mounted in the film body. The film body is transparent, film-shaped, and flexible. The graphene unit includes multiple graphene elements (21). The graphene elements are distributed evenly in the film body. The photocatalyst unit includes multiple titanium dioxide elements (31). The titanium dioxide elements are distributed evenly in the film body. Thus, the visible light enhancement film converts part of invisible light into visible light, to increase the power generation efficiency and the photosynthesis effect.

## Description

The present invention relates to a film and, more particularly, to a visible light enhancement film.

A conventional solar power generation module is used to convert an optical energy into an electric energy to generate an electric power. However, the conventional solar power generation module only has an energy conversion efficiency of about 15% to 30%. In addition, the conventional solar power generation module only has a life span is about 20 to 30 years. In practice, when the solar power generation module is installed outdoors, foreign matters, such as dust, suspended particles, compost, biomass waste, bird excrement or the like, are easily accumulated on its surface, thereby hindering or refraining absorption of the sunlight, and thereby decreasing the power generation efficiency.

The primary objective of the present invention is to provide a visible light enhancement film that converts part of invisible light into visible light, to increase the power generation efficiency and the photosynthesis effect. In addition, the visible light enhancement film always keeps clean and has a sterilizing effect.

In accordance with the present invention, there is provided a visible light enhancement film comprising a film body, a graphene unit mounted in the film body, and a photocatalyst unit mounted in the film body. The film body is transparent, film-shaped, and flexible. The graphene unit includes multiple graphene elements. The graphene elements are distributed evenly in the film body. The photocatalyst unit includes multiple titanium dioxide elements. The titanium dioxide elements are distributed evenly in the film body.

Further benefits and advantages of the present invention will become apparent after a careful reading of the detailed description with appropriate reference to the accompanying drawings.

In the drawings:
**FIG. 1** is a perspective view of a visible light enhancement film in accordance with the preferred embodiment of the present invention.
**FIG. 2** is a cross-sectional view of the visible light enhancement film as shown in FIG. 1.
**FIG. 3** is a schematic view showing a first operation state of the visible light enhancement film as shown in FIG. 1.
**FIG. 4** is a schematic view showing a second operation state of the visible light enhancement film as shown in FIG. 1.

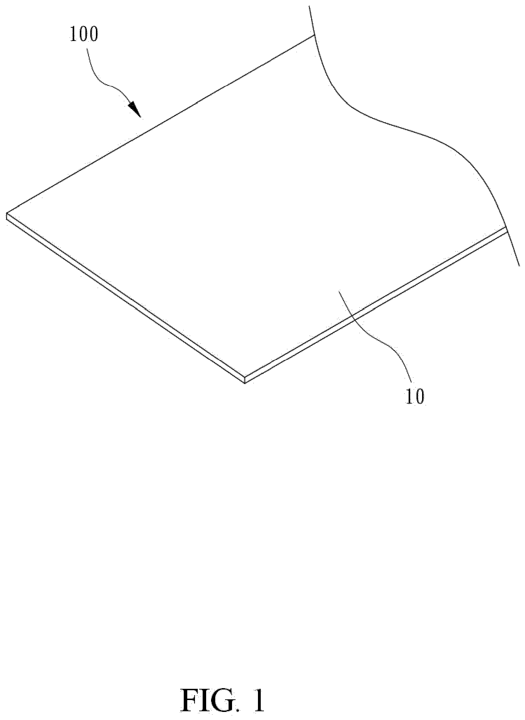

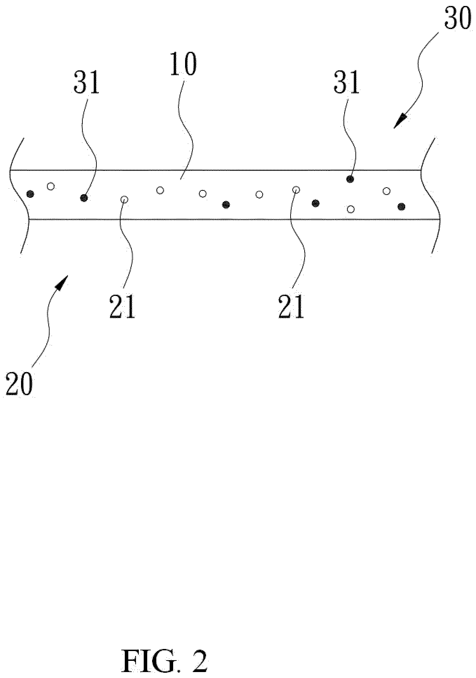

Referring to the drawings and initially to FIGS. 1 and 2, a visible light enhancement film 100 in accordance with the preferred embodiment of the present invention comprises a film body (or membrane) 10, a graphene unit 20 mounted in the film body 10, and a photocatalyst (or photo catalyst) unit 30 mounted in the film body 10.

The film body 10 is transparent, film-shaped, and flexible.

The graphene unit 20 includes multiple graphene elements 21. The graphene elements 21 are distributed evenly in the film body 10 when the film body 10 is formed.

The photocatalyst unit 30 includes multiple titanium dioxide elements 31. The titanium dioxide elements 31 are distributed evenly in the film body 10 when the film body 10 is formed.

In the preferred embodiment of the present invention, the film body 10 is made of polyethylene (PE).

In the preferred embodiment of the present invention, the film body 10 has a thickness ranged between 50µm and 100µm.

In the preferred embodiment of the present invention, the graphene elements 21 have a volume that is 1-5% of that of the film body 10.

In the preferred embodiment of the present invention, the graphene elements 21 are transparent.

In the preferred embodiment of the present invention, the titanium dioxide elements 31 have a volume that is 1-5% of that of the film body 10.

In the preferred embodiment of the present invention, the titanium dioxide elements 31 are transparent.

It is noted that, the energy distribution of the sunlight spectrum is divided into visible light and invisible light, with the visible light accounting for approximately 47% of the optical energy, and with the invisible light (including ultraviolet light and infrared light) accounting for approximately 53% of the optical energy. A solar power generation process converts an energy of the visible light into an electrical energy through a photoelectric conversion. The invisible light cannot be converted, and will produce a heat energy that decreases the power generation efficiency of the visible light.

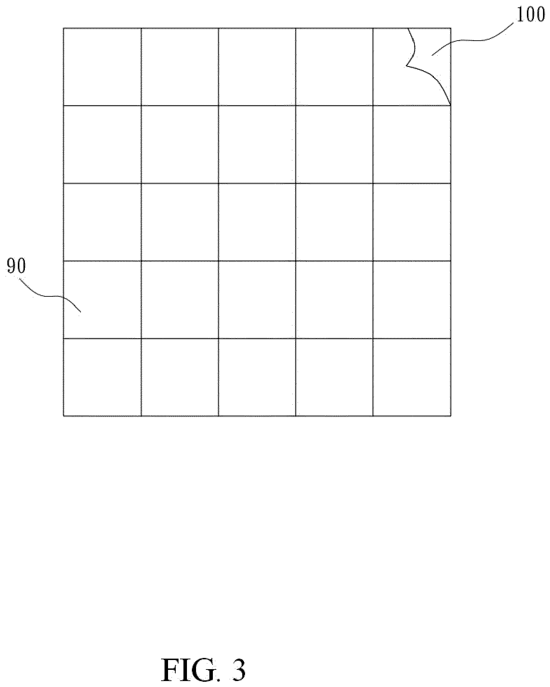

Referring to FIG. 3 with reference to FIGS. 1 and 2, the visible light enhancement film 100 is stuck to a surface of a solar panel 90 and directed toward the sunlight.

In such a manner, the visible light enhancement film 100 contains the graphene that will produce a surface plasma (or plasmon) resonance when being subjected to an ambient light, to reduce the transmission speed of light, and to change the wavelength of light. This phenomenon is called "optical phase resonance". Thus, the visible light enhancement film 100 converts infrared radiation with a longer wavelength into visible light with a shorter wavelength through the unique optical feature of the graphene.

In practice, when an infrared light source is projected on the graphene, the optical property of the graphene will be changed, so that part of the infrared light is absorbed and converted into the short-wavelength visible light that can increase the photoelectric conversion of the solar panel 90 to increase the power generation. Preferably, experiments show that the power generation is increased by about 5-20% (different environment conditions have different effects).

Thus, the visible light enhancement film 100 converts part of the invisible light into visible light to increase the power generation. In addition, the energy accumulated on the solar panel 90 is decreased due to reduction of the invisible light, so that the visible light enhancement film 100 increases the heat dissipation effect of the solar panel 90 and enhances the working efficiency of the solar panel 90.

Further, the photocatalyst unit 30 includes the titanium dioxide elements 31. In such a manner, the titanium dioxide elements 31 produce free hydroxyl radicals after absorbing enough light energy. Thus, bacteria or viruses attached on the surface of the visible light enhancement film 100 are killed, to keep the cleanliness and enhance the lifetime of the visible light enhancement film 100.

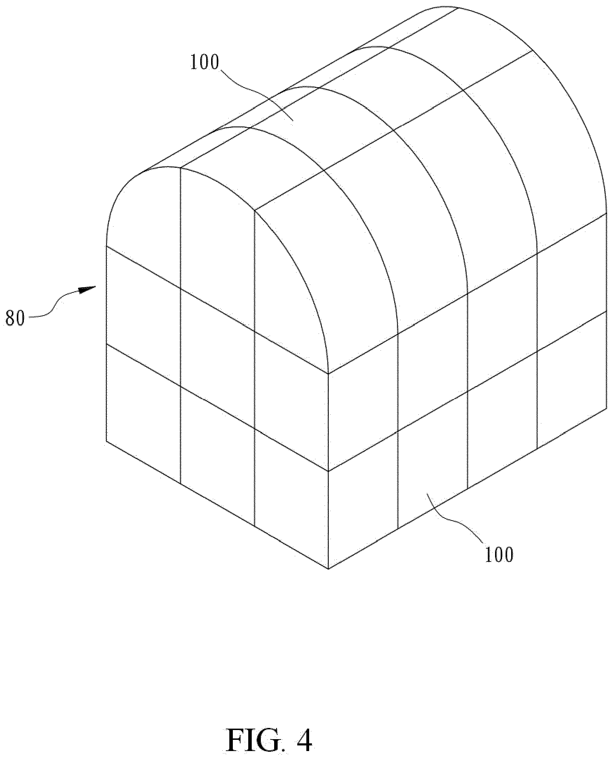

Referring to FIG. 4 with reference to FIGS. 1 and 2, the visible light enhancement film 100 covers an agricultural greenhouse 80. Thus, the graphene of the visible light enhancement film 100 increases the visible light to promote photosynthesis of crops grown in the agricultural greenhouse 80, and to enhance the growth efficiency of crops. In addition, the titanium dioxide elements 31 of the visible light enhancement film 100 keeps the cleanliness and enhances the lifetime of the agricultural greenhouse 80.

Although the invention has been explained in relation to its preferred embodiment(s) as mentioned above, it is to be understood that many other possible modifications and variations can be made without departing from the scope of the present invention. It is, therefore, contemplated that the appended claim or claims will cover such modifications and variations that fall within the scope of the invention.

## Claims

1. A visible light enhancement film (100) comprising:
a film body (10);
a graphene unit (20) mounted in the film body; and
a photocatalyst unit (30) mounted in the film body;
wherein:
the film body is transparent, film-shaped, and flexible;
the graphene unit includes multiple graphene elements (21);
the graphene elements are distributed evenly in the film body;
the photocatalyst unit includes multiple titanium dioxide elements (31); and
the titanium dioxide elements are distributed evenly in the film body.

2. The visible light enhancement film as claimed in claim 1, wherein the film body is made of polyethylene (PE).

3. The visible light enhancement film as claimed in claim 1, wherein the film body has a thickness ranged between 50µm and 100µm.

4. The visible light enhancement film as claimed in claim 1, wherein the graphene elements have a volume that is 1-5% of that of the film body.

5. The visible light enhancement film as claimed in claim 1, wherein the graphene elements are transparent.

6. The visible light enhancement film as claimed in claim 1, wherein the titanium dioxide elements have a volume that is 1-5% of that of the film body.

7. The visible light enhancement film as claimed in claim 1, wherein the titanium dioxide elements are transparent.
